(19) Europäisches Patentamt
European Patent Office
Office européen des brevets

(11) EP 1 553 807 A1

(12) EUROPEAN PATENT APPLICATION
published in accordance with Art. 158(3) EPC

(43) Date of publication:
13.07.2005 Bulletin 2005/28

(51) Int Cl.⁷: H05B 33/04, H05B 33/10, H05B 33/12

(21) Application number: 03754148.9

(22) Date of filing: 16.10.2003

(86) International application number:
PCT/JP2003/013234

(87) International publication number:
WO 2004/036960 (29.04.2004 Gazette 2004/18)

(84) Designated Contracting States:
AT BE BG CH CY CZ DE DK EE ES FI FR GB GR HU IE IT LI LU MC NL PT RO SE SI SK TR

(30) Priority: 16.10.2002 JP 2002301852

(71) Applicant: IDEMITSU KOSAN CO., LTD.
Tokyo 100-8321 (JP)

(72) Inventors:
• EIDA, Mitsuru
Sodegaura-shi, Chiba 299-0293 (JP)

• KUMA, Hitoshi
Sodegaura-shi, Chiba 299-0293 (JP)
• HOSOKAWA, Chishio
Sodegaura-shi, Chiba 299-0293 (JP)

(74) Representative:
Gille, Struck, Neidlein, Prop, Roos
Patentanwälte
Brucknerstrasse 20
40593 Düsseldorf (DE)

(54) **ORGANIC ELECTROLUMINESCENT DISPLAY AND METHOD FOR MANUFACTURING SAME**

(57) An organic electroluminescent display including: a supporting substrate; an organic electroluminescent element; a first passivation layer; a second passivation layer; a color conversion layer for adjusting and/or converting the color of a light emitted from the organic electroluminescent element; and a transparent substrate formed in sequence. Since the display has two passivation layers, a pinhole pass can be effectively blocked, thereby enhancing the sealing properties. Consequently a non-emission region such as a dark spot is hardly formed, and therefore the display can have excellent durability.

Fig.1

5...Color Conversion Layer
6...Transparent Substrate
9...Flattening Layer
4...Second Passivation Layer
3...First Passivation Layer
2...Organic EL Element
1...Supporting Substrate
8...Insulative Member
7...TFT

EP 1 553 807 A1

**Description**

Technical Field

The present invention relates to an organic EL (electroluminescent) display and its production, the display suitably employed in displays for personal and industrial uses, specifically cell-phone, PDA, car-navigation, monitor, television and the like.

Background Art

An organic EL display is constructed from organic EL elements with an organic luminescent medium held between opposite electrodes. If a voltage is applied across the electrodes, electrons injected from one electrode recombine with holes from another electrode in an organic emitting layer of the organic luminescent medium. The organic luminescent molecules in the organic emitting layer change to the exited state by the recombination energy and then return to the ground state. At this time energy is discharged. The organic EL element emits light by taking out this energy as light.

An organic EL display constructed from organic EL elements of such luminescent principle is completely solid and characterized by excellent visibility, light weight, thin thickness, and low driving voltage of several volts. Thus organic EL displays are expected to be used as color displays and have been eagerly researched at present.

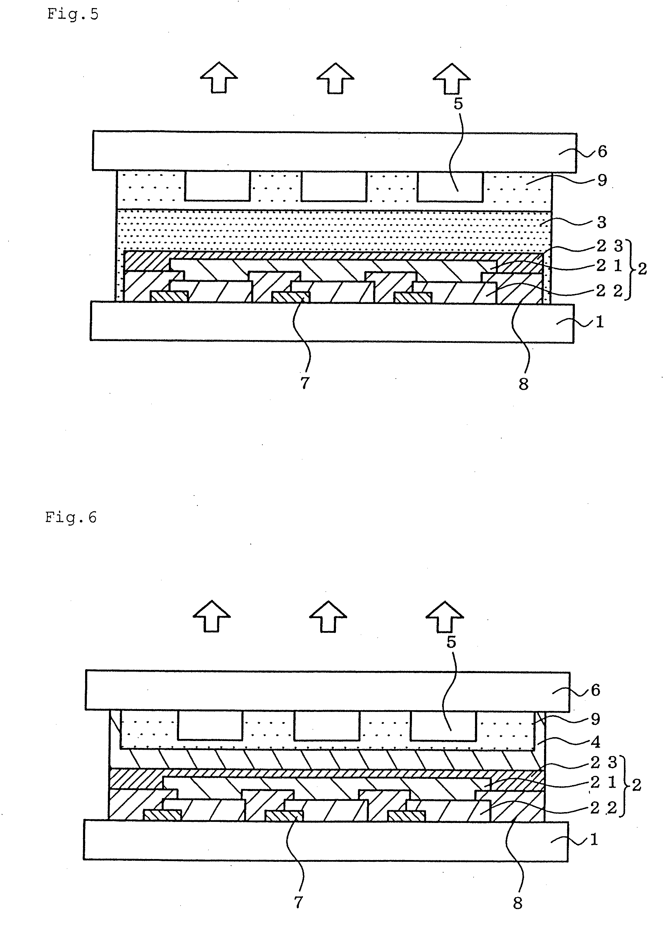

Figs. 5 and 6 show examples of conventional organic EL displays.

In the organic EL display shown in Fig. 5 (for example, US-B-6268695 and JP-A-2000-223264), TFTs 7 and under electrodes 22 are formed on a supporting substrate 1. Insulative members 8, organic luminescent mediums 21, upper electrodes 23, a passivation layer 3, a flattening layer 9 and color conversion layers 5 are sequentially formed thereon. A transparent substrate 6 is arranged on the uppermost surface. An under electrode 22, organic luminescent medium 21 and upper electrode 23 constitute an organic EL element 2. The passivation layer 3 performs the function of sealing, and prevents undesired materials generated from and impurities contained in the color conversion layers 5 from penetrating and transmitting into the organic EL elements 2.

In the organic EL display shown in Fig. 6 (for example, JP-A-H10-12383, JP-A-H8-279394 and JP-A-H11-260562), TFTs 7 and under electrodes 22 are formed on a supporting substrate 1. Insulative members 8, organic luminescent mediums 21, upper electrodes 23, a passivation layer 4, a flattening layer 9 and color conversion layers 5 are sequentially formed thereon. A transparent substrate 6 is arranged on the uppermost surface.

These organic EL displays are of so-called top emission type on the basis of the supporting substrate of organic EL element. The color conversion layers 5 adjust/convert light emitted from the organic EL elements 2 and desired light is taken out through the transparent substrate 6. Arrows in the figures show the direction of taking out light.

These organic EL displays are required to improve their durability. That is, in the organic EL display shown in Fig. 5, the conditions under which the passivation layer 3 is formed on the organic EL elements 2 cannot be severe, since the organic luminescent mediums 21 constituting the organic EL elements 2 are organic materials liable to be damaged. Further volatile components may be generated from the organic luminescent mediums 2 when forming the passivation layer 3. As a result, there is the following possibility; A passivation layer 3 is neither densified nor pin-hole less. Volatile components such as monomers and water generated from the color conversion layers 5 transmit through the passivation layer 3. Non-emitting parts such as dark spots then occur in the emitting area of the organic EL elements 2. Consequently an organic EL display with a high durability cannot be obtained.

In the organic EL display shown in Fig. 6, the conditions under which the passivation layer 4 is formed on the color conversion layers 5 cannot be severe, since the color conversion layers 5 contain organic materials liable to be damaged. Further volatile components may be generated from the color conversion layers 5 when forming the passivation layer 4. As a result, there is the following possibility; A passivation layer 4 is neither densified nor pin-hole less. Volatile components such as monomers and water generated from the color conversion layers 5 transmit through the passivation layer 4. Non-emitting parts such as dark spots then occur in the emitting area of the organic EL elements 2. Consequently an organic EL display with a high durability cannot be obtained.

The present invention is made to solve the above problems and an object thereof is to provide an organic EL display excellent in duability with less occurrence of non-emitted parts such as dark spots and a production method thereof.

Disclosure of the Invention

According to the present invention, there are provided the following organic EL display and its production method.

[1] An organic electroluminescent display comprising:

a supporting substrate;
an organic electroluminescent element;
a first passivation layer;
a second passivation layer;
a color conversion layer for adjusting and/or converting the color of a light emitted from the organic electroluminescent element; and
a transparent substrate formed in sequence.

[2] An organic electroluminescent display according to 1,
wherein the following formula is satisfied,

$$0.001\ \mu m < T1+T2 < 200\ \mu m$$

wherein T1 is the film thickness of the first passivation layer, and T2 is the film thickness of the second passivation layer.

[3] An organic electroluminescent display according to 1 or 2, further comprising an intermediate layer between the first passivation layer and the second passivation layer.

[4] An organic electroluminescent display according to 3,
wherein the intermediate layer comprises an inert fluid.

[5] An organic electroluminescent display according to any one of 1 to 4, wherein the color conversion layer comprises a fluorescent medium.

[6] A process for producing an organic electroluminescent display, comprising:

arranging an organic electroluminescent element and a first passivation layer on a supporting substrate to form a first substrate;
arranging a color conversion layer for adjusting and/or converting the color of a light emitted from the organic electroluminescent element, and a second passivation layer on a transparent substrate to form a second substrate; and
attaching the first substrate to the second substrate such that the first passivation layer faces the second passivation layer.

Another layer can be provided in the constituent members so far as advantageous effects of the present invention can be obtained.

Brief Description of the Drawings

Fig. 1 is a schematic view describing an organic EL display that is an embodiment according to the present invention;
Fig. 2 is a view showing the steps of forming a polysilicon TFT;
Figs. 3 is a circuit diagram showing the connection structure of electric switch with the polysilicon TFT;
Fig. 4 is a plane view showing the connection structure of electric switch with the polysilicon TFT;
Fig. 5 is a schematic view showing a conventional organic EL display;
Fig. 6 is a schematic view showing a conventional organic EL display;

Best Modes for Carrying Out the Invention

An organic EL display of the present invention will be described with reference to drawings.

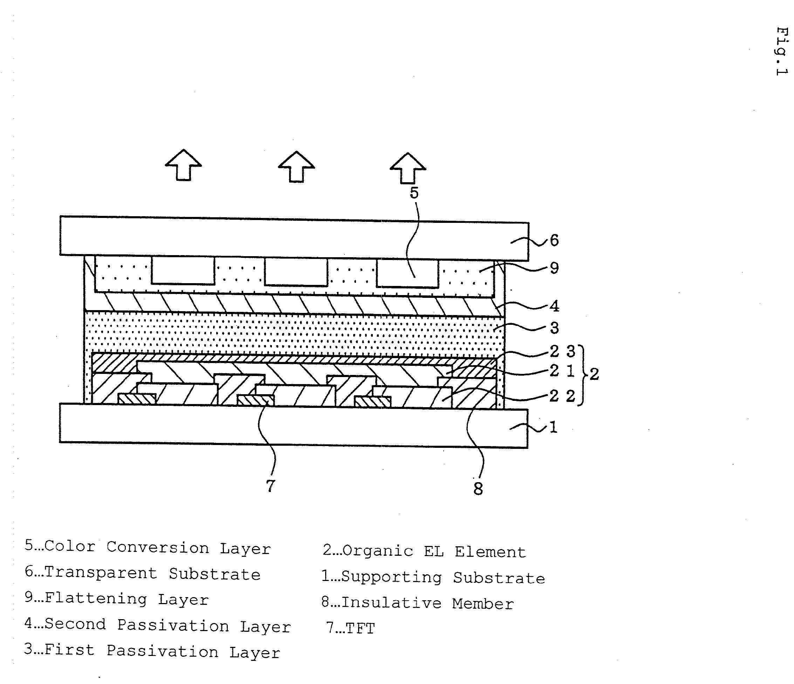

Fig. 1 is a schematic view showing an organic EL display that is an embodiment according to the present invention.
In the organic EL display shown in this figure, TFTs 7 and under electrodes 22 are formed on a supporting substrate 1. Insulative members 8, organic luminescent mediums 21, upper electrodes 23, a first passivation layer 3, a second passivation layer 4, a flattening layer 9 and color conversion layers 5 are sequentially formed thereon. A transparent substrate 6 is arranged on the uppermost surface. An under electrode 22, an organic luminescent medium 21 and an upper electrode 23 constitute an organic EL element 2. Arrows show the direction of taking our light. This device is of top emission type where light is taken out from the side opposite to the supporting substrate 1.

Upon applying voltage across the under and upper electrodes 22 and 23, the organic luminescent mediums 21 therebetween emit light. The light passes through the first and second passivation layers 3 and 4 to the color conversion layers 5. The color conversion layers 5 adjust/convert the color of light emitted by the organic EL elements 2 to emit red, green or blue light as needed. The light of three colors is taken out through the transparent substrate 6.

In this device, two layers of the first and second passivation layers 3 and 4 are provided as a passivation layer. Thus even if a pin hole occurs in one passivation layer, another passivation layer can effectively obstruct the path of the pin hole. Consequently non-emitting parts are hardly generated in the device with an enhanced sealing property. As a result there can be provided an organic EL display with a synergistically high durability.

The passivation layers 3 and 4 may be the same as or different from each other. The materials and thicknesses of passivation layers will be described later.

Next a process for producing the organic EL display is described below.

Firstly the organic EL elements 2 and insulative members 8 are formed on the supporting substrate 1 by a known method and sealed with the first passivation layer 3 to obtain an organic EL element substrate (first substrate)

The color conversion layers 5 are formed on the transparent substrate 6 by a known method and flattened with the flattening layer 9. The resultant substrate is then sealed with the second passivation layer 4 to obtain a color conversion substrate (second substrate).

Next the organic EL element substrate is adhered to the color conversion substrate such that the first passivation layer 3 faces the second passivation layer 4, thereby forming the organic EL display of the embodiment. Both the substrates can be adhered with an adhesive and the like.

In the process, the elution of organic components and generation of gas and the like can be suppressed in the production line, since the organic EL element substrate and color conversion substrate are sealed with the passivation layers, respectively. Further the moisture control can be easily performed, since care may not be taken to the absorption of water to the substrates. In addition, these substrates can be easily handled similarly to a glass substrate. They can be washed after they have been produced.

Thus the process of the embodiment can facilitate the handling at the time of production and enhance the manufacturing efficiency compared with, for example, a process where each layer is laminated on a substrate.

The present invention is not limited to the embodiment and various modifications may be made. For example, an intermediate layer such as an adhesive layer or stress relaxation layer may be provided between the first and second passivation layers 3 and 4. A proper intermediate layer can not only relax a (mechanical or thermal) stress difference between the organic EL element and color conversion substrates but also prevent the braking of the first and second passivation layers 3 and 4 caused by their contact. The material of intermediate layer is not limited but the intermediate layer is preferably made of an inert fluid. The inert fluid is a fluid that does not oxidizes a cathode of the organic EL elements 2 and neither penetrates into nor is dissolved in organic materials of the organic EL elements 2. Illustrative examples thereof are inert gases such as nitrogen, argon and helium, and inert liquids such as fluoro-hydrocarbons and silicon oils. Among these, fluoro-hydrocarbons are preferred.

A stress relaxation layer is preferably made of a highly-elastic material with transparency, small Yong's modulus and high tension rate. Various gels and rubbers such as silicone rubbers are exemplified. Such a material preferably has a Yong's modulus of 0.1 to 10 MPa to relax stress. It preferably has a transmittance of 50% or more in the case where light is taken out through the stress relaxation layer. The thickness of the stress relaxation layer is not limited so far as the layer can sufficiently absorb stress and impact. However the layer preferably have a substantially uniform and thin thickness to make an organic EL display thin, for example 0.001μm to 200μm, more preferably 0.01μm to 10μm. If the layer has a thickness thinner than 0.001μm, it may not sufficiently absorb stress and impact. If the layer has thickness thicker than 200μm, the display properties of an organic EL display may be remarkably degraded, for example, color mixture may reduce its color reproducibility and increase the viewing angle dependency. The layer can be formed by application (spin coater, roll coater) and so on.

The stress relaxation layer may be constructed of spacers distributed and filler filling space between spacers. Materials of the spacers include silica spacers, plastic spacers and glass. Fillers include liquid silicone The spacers can be formed with a spacer distributing device used in apparatuses for manufacturing liquid crystal displays.

Instead of the spacers, separating walls and a drying agent may be provided as an intermediate layer. An organic film such as carbon nitride may be provided as an intermediate layer for relaxing stress.

Three or more passivation layers may be arranged.

The present invention can be suitably applied to devices with no TFTs although the device with TFTs has been described above as the embodiment.

Next the constituent members of the organic EL display in the embodiment will be each described below. Ordinary members and structures can be applied if not otherwise specified. Among these, the most suitable one can be selected in the device of the present invention.

1. Supporting substrate

The supporting substrate in the organic EL display is a member for supporting the organic EL element and the like. Therefore the substrate is preferably excellent in mechanical strength and dimension stability.

Materials for such a substrate include glass plates, metal plates, ceramic plates and plastic plates such as polycarbonate resins, acrylic resins, vinyl chloride resins, polyethylene terephthalate resins, polyimide resins, polyester resins, epoxy resins, phenol resins, silicon resins, fluorine-containing resins and polyethersulfone resins.

In order to avoid the invasion of moisture into the organic EL display, the supporting substrate 1 made of these materials is preferably subjected to a moisture proof treatment or hydrophobic treatment by forming an inorganic film or applying a fluorine-containing resin.

In particular, in order to avoid the invasion of moisture into the organic luminescent medium, the supporting substrate preferably has a small water content and gas permeability coefficient. Specifically, preferred water content and gas permeability coefficient are 0.0001% by weight or less and $1 \times 10^{-13}$ cc·cm/cm$^2$·sec.cmHg or less, respectively.

In order to take out EL emission from the side opposite to the supporting substrate, that is, the upper electrode side in the invention, the supporting substrate is not necessarily transparent.

2. Organic EL element

Generally the organic EL element is constructed of the organic luminescent medium, the upper electrode and the under electrode which hold the medium therebetween. Each constituent element of the organic EL element, i.e. organic luminescent medium (1), upper electrode (2) and under electrode (3) will be sequentially described below.

(1) Organic luminescent medium

The organic luminescent medium can be defined as a medium containing an organic luminescent layer wherein electrons and holes are recombined with each other, thereby allowing EL emission. This organic luminescent medium can be made, for example, by laminating the following layers (a) to (g) on an anode:

(a) Organic luminescent layer
(b) Hole injecting layer/organic luminescent layer
(c) Organic luminescent layer/electron injecting layer
(d) Hole injecting layer/organic luminescent layer/electron injecting layer
(e) Organic semiconductor layer/organic luminescent layer
(f) Organic semiconductor layer/electron barrier layer/organic luminescent layer
(g) Hole injecting layer/organic luminescent layer/adhesion improving layer

Among these (a) to (g), the structure (d) is preferably used since it can give a higher luminescent brightness and is also superior in durability.

(i) Organic luminescent layer
Examples of luminous materials of the organic luminescent layer include only one or combinations of two or more selected from p-quaterphenyl derivatives, p-quinquephenyl derivatives, benzodiazole compounds, benzimidazole compounds, benzoxazole compounds, metal-chelated oxynoid compounds, oxadiazole compounds, styrylbenzene compounds, distyrylpyrazine derivatives, butadiene compounds, naphthalimide compounds, perylene derivatives, aldazine derivatives, pyraziline derivatives, cyclopentadiene derivatives, pyrrolopyrrole derivatives, styrylamine derivatives, coumarin compounds, aromatic dimethylidyne compounds, metal complexes having an 8-quinolinol derivative as a ligand, and polyphenyl compounds.
Among these organic luminous materials, 4,4'-bis(2,2-di-t-butylphenylvinyl)biphenyl (abbreviated to DTBPBBi), 4,4'-bis(2,2-diphenylvinyl)biphenyl (abbreviated to DPVBi), and derivatives thereof, as aromatic dimethylidyne compounds, are more preferable.
Furthermore, it is preferred to use together a material where an organic luminescent material having a distyrylarylene skeleton or the like, as a host material, is doped with a fluorescent dye giving intense from blue to red fluorescence, for example, a coumarin material, or a fluorescent dye similar to that used as a host, as a dopant More specifically, it is preferred to use the above-mentioned DPVBi or the like as a host and 1,4-bis[4-(N,N-diphenylaminostyrylbenzene)] (abbreviated to DPAVB) as a dopant.
(ii) Hole injecting layer
Compounds having a hole mobility of $1 \times 10^{-6}$ cm$^2$/v·s or more measured at an applied voltage of $1 \times 10^4$ to $1 \times 10^6$ V/cm and an ionization energy of 5.5 eV or less are preferably used in a hole injecting layer. Such a hole injecting layer enables good hole injection into an organic emitting layer, thereby enhancing a luminescence brightness or allowing low voltage drive.

Examples of a constituent material for the hole injection layer include porphyrin compounds, aromatic tertiary amine compounds, styrylamine compounds, aromatic dimethylidine compounds, condensed aromatic ring compounds and organic compounds such as 4,4-bis[N-(1-naphthyl)-N-phenylamino]biphenyl (abbreviated NPD) and 4,4',4"-tris[N-(3-methylphenyl)-N-phenylamino]triphenylamine (abbreviated MTDATA).

Inorganic compounds such as p-type Si and P-type SiC are preferably used as a constituent material for the hole injection layer.

It is also preferred that an organic semiconductive layer having an electrical conductivity of $1 \times 10^{-10}$ S/cm or more is formed between the above hole injecting layer and an anode, or between the above hole injecting layer and an organic emitting layer. Such an organic semiconductive layer enables better hole injection into an organic emitting layer.

(iii) Electron injecting layer

Compounds having an electron mobility of $1 \times 10^{-6}$ cm$^2$/v·s or more measured at an applied voltage of $1 \times 10^4$ to $1 \times 10^6$ V/cm and an ionization energy more than 5.5 eV are preferably used in an electron injecting layer. Such an electron injecting layer enables good electron injection into an organic emitting layer, thereby enhancing a luminescence brightness or allowing low voltage drive.

Examples of a constituent material for the electron injecting layer include 8-hydroxyxinoline metal complexes such as Al chelate: Alq, derivatives thereof or oxadiazole derivatives.

(iv) Adhesion improving layer

An adhesion improving layer is a form of the electron injecting layer. That is, it is a special layer comprising a material with good adhesion properties to a cathode among electron injecting layers. The adhesion improving layer is preferably made of a material such as 8-hydroxyxinoline metal complexes or derivatives thereof.

It is also preferred that an organic semiconductor layer with an electric conductivity of $1 \times 10^{-10}$ S/cm or more is formed in contact with the above electron injecting layer. Such an organic semiconductor layer enables good electron injecting into an organic emitting layer.

(v) Thickness of the organic luminescent medium

The thickness of the organic luminescent medium is not particularly limited. However it is preferably in the range of, for example, 5nm to 5μm. If the thickness is below 5nm, the luminescent brightness and durability thereof may deteriorate, while if it is over 5μm, the value of the voltage to be applied may become high. Therefore, the thickness of the organic luminescent medium is more preferably 10nm to 3μm, and still more preferably 20nm to 1μm.

(2) Upper electrode

In the embodiments, the upper electrode is arranged over entire the surface of display area.

The upper electrode corresponds to an anode or a cathode layer dependently on the structure of the organic EL element. In the case that the upper electrode corresponds to an anode layer, it is preferred to use a material having a large work function, for example, 4.0 eV or more, in order to make hole-injection easy. In the case that the upper electrode corresponds to a cathode layer, it is preferred to use a material having a work function of less than 4.0 eV in order to make electron-injection easy.

In organic EL displays of top emission type, it is necessary for the upper electrode to have transparency in order to get light out through the upper electrode. Accordingly, in the case that the upper electrode 23 corresponds to the anode layer, materials for the upper electrode include only one or combinations of two or more selected from indium tin oxide (ITO), indium zinc oxide (IZO), copper indium (CuIn), tin oxide ($SnO_2$), zinc oxide (ZnO), antimony oxide ($Sb_2O_3$, $Sb_2O_4$, $Sb_2O_5$), aluminum oxide ($Al_2O_3$) and so on.

In order to decrease the resistance of the upper electrode without damaging transparency, only one or combination of two or more selected from metals such as Pt, Au, Ni, Mo, W, Cr, Ta and Al is preferably added.

A constituent material of the upper electrode can be selected from the group consisting of light transmitting metal films, nondegenerate semiconductors, organic conductors, semiconductive carbon compounds and so on. Preferred organic conductors include conductive conjugated polymers, oxidizer-added polymers, reducer-added polymers, oxidizer-added low molecules or reducer-added low molecules.

Examples of oxidizers added to an organic conductor include Lewis acids such as iron chloride, antimony chloride and aluminum chloride. Further Examples of reducers added to an organic conductor include alkali metals, alkali-earth metals, rare-earth metals, alkali compounds, alkali-earth compounds or rare-earth compounds. Examples of conductive conjugated polymers include polyanilines and derivatives thereof, polytiophens and derivatives thereof and Lewis-acid-added amine compounds.

Preferred examples of nondegenerate semiconductors include oxides, nitrides or chalcogenide compounds.

Preferred examples of carbon compounds include amorphous C, graphite or diamond like C.

Examples of inorganic semiconductors include ZnS, ZnSe, ZnSSe, MgS, MgSSe, CdS, CdSe, CdTe or CdSSe.

The thickness of the upper electrode is decided preferably its sheet resistance or the like. For example, the thickness of the upper electrode is preferably in the range of 50nm to 5000nm, more preferably 100nm or more. Such a thickness allows a uniform thickness distribution and light transmission of 60% or more of EL emission as well as a sheet resistance of the upper electrode of $15\Omega/\square$ or less, more preferably $10\Omega/\square$ or less.

(3) Under electrode

In the embodiments, the under electrode is individually separatively arranged per pixel in a plane pattern.

The under electrode corresponds to an anode or cathode layer dependently on the structure of the organic EL display. In the case that the under electrode corresponds to a cathode layer, it is preferred to use a material having a smaller work function, for example, a metal, an alloy, an electrically conductive compound, a mixture thereof or a material containing at least one of them having a work function of less than 4.0 eV.

As such materials, for example, it is preferred to use one or a combination of two or more selected from sodium, sodium-potassium alloys, cesium, magnesium, lithium, magnesium-silver alloys, aluminum, aluminum oxide, aluminum-lithium alloys, indium, rare earth metals, mixtures of these metals and organic luminescence medium materials, mixtures of these metals and electron injecting layer materials, and so on.

In the invention, it is not necessary for materials of the under electrode to have transparency since luminescence is got from the upper electrode side. It is preferably made rather from light-absorbing conductive materials. This structure enhances the display contrast of organic EL display. In this case, preferable light-absorbing conductive materials include semiconductive carbonate materials, colored organic compounds, combinations of the above reducers and oxidizers, and colored conductive oxide (transition metal oxides such as VOx, MoOx, WOx and etc.).

The thickness of the under electrode is not particularly limited as well as the upper electrode. However, it is preferably in the range of, for example, 10nm to 1000nm, more preferably 10nm to 200nm.

3. Insulative member

The insulative member (electric insulator) in the organic EL display of the embodiments is formed near or around the organic EL element. The insulative member is used for high resolution of a whole organic EL display, and for prevention of short circuits between the under and upper electrodes. In the case that the organic EL element is driven by the TFTs, the insulative member is also used for protection of the TFTs and as a base for coating of the under electrode of the organic EL element flatly.

Therefore, the insulative member may be called, a partition, a spacer, a flattening film or the like if necessary. The invention embraces all of them.

In the embodiments the insulative members are provided to bury gaps between the under electrodes formed separately disposed per pixel. That is, the insulative members are disposed along boundaries between pixels.

Examples of materials for the insulative member usually include acrylic resins, polycarbonate resins, polyimide resins, fluorinated polyimide resins, benzoguanamine resins, melamine resins, cyclic polyolefins, Novolak resins, polyvinyl cinnamates, cyclic rubbers, polyvinyl chloride resins, polystyrenes, phenol resins, alkyd resins, epoxy resins, polyurethane resins, polyester resins, maleic acid resins, and polyamide resins.

In the case that the insulative member is made of an inorganic oxide, preferred inorganic oxides include silicon oxide ($SiO_2$ or $SiO_x$), aluminum oxide ($Al_2O_3$ or $AlO_x$), titanium oxide ($TiO_3$ or $TiO_x$), yttrium oxide ($Y_2O_3$ or $YO_x$), germanium oxide ($GeO_2$ or $GeO_x$), zinc oxide (ZnO), magnesium oxide (MgO), calcium oxide (CaO), boric acid ($B_2O_3$), strontium oxide (SrO), barium oxide (BaO), lead oxide (PbO), zirconia ($ZrO_2$), sodium oxide ($Na_2O$) lithium oxide ($Li_2O$), potassium oxide ($K_2O$).

The value x in the above inorganic compounds is in the range of $1 \leq x \leq 3$.

In the case that heat-resistance is required for the member, it is preferred to use acrylic resins, polyimide resins, fluorinated polyimides, cyclic olefins, epoxy resins, or inorganic oxides.

These insulative members, when being organic, can be worked into a desired pattern by introducing a photosensitive group thereto and using a photolithography method, or can be formed into a desired pattern by printing.

The thickness of the insulative member depends on the resolution of display, or unevenness of other members combined with the organic EL element, and is preferably 10 nm to 1 mm. This is because such a structure makes it possible to make the unevenness of the TFTs and the like sufficiently flat.

Accordingly, the thickness of the insulative member is more preferably 100 nm to 100 $\mu$m, and still more preferably 100 nm to 10 $\mu$m.

4. Passivation layer

Examples of materials for the passivation layer include transparent resins, sealing liquids and transparent inorganic materials. In the present invention, the constituent material of the first passivation layer may be the same as or different from that of the second passivation layer. Each passivation layer may be of monolayer or multi-layer structure.

Examples of transparent resins which can be used as a constituent material for the passivation layer include polyphenyl methacrylate, polyethylene terephthalate, poly-o-chlorostyrene, poly-o-naphthyl methacrylate, polyvinyl naphthalene, polyvinyl carbazole and polyester containing fluorene skeleton.

In case of using a transparent resin as a material for the passivation layer, it is preferably to comprise ultravioiet-ray curing resins, visible light curing resins, thermosetting resins or adhesives using them. Specific examples thereof include commercially available products such as Luxtrak LCR0278, 0242D (both of which are made by Toagosei Co., Ltd.), TB3102 (epoxy type, made by Three Bond Co., Ltd.)and Venefix VL (acrylic type, made by Adel Co., Ltd.).

Examples of transparent inorganic materials which can be used as a material constituting the passivation layer include $SiO_2$, $SiO_x$, $SiO_xN_y$, $Si_3N_4$, $Al_2O_3$, $AlO_xN_y$, $TiO_2$, $TiO_x$, $SiAlO_xN_y$, $TiAlO_x$, $TiAlO_xN_y$, $SiTiO_x$ and $SiTiO_xN_y$ wherein x is preferably 0.1 to 4 and y is preferably 0.1 to 3. The materials also include a sodium-lime grass; grasses containing barium and strontium; lead grass; aluminosilicate grass; borosilicate glass; bariumborosilicate glass, pyrex grass; vycor grass; grasses containing at least a silicon oxide, boron oxide and aluminum oxide; grasses containing at least a silicon oxide, boron oxide, aluminum oxide and alkaline metal oxide; grasses containing at least a silicon oxide, boron oxide, aluminum oxide and alkaline earth metal oxide; and grasses containing at least a silicon oxide, boron oxide, aluminum oxide and rare earth metal oxide. In these glasses, elements with a small atomic diameter form network around elements with a large atomic diameter. By using such glasses, a more densified passivation layer can be preferably formed.

A passivation layer may be preferably formed by repeatedly laminating these transparent inorganic materials and transparent resins. Even if a pin hole is formed in a film of a transparent inorganic material, a transparent resin can fill the pin hole and flatten the film, thereby preventing the generation of a pin hole.

A passivation layer may be preferably formed by repeatedly laminating these transparent inorganic materials and carbon nitride. Carbon nitride can absorb stress of a transparent inorganic material, thereby enhancing thermal shock resistance and preventing cracks and so on.

In the case of using a transparent inorganic material in the passivation layer, the film is preferably formed at a low temperature (100°C or lower) and a slow film-forming speed in order that the organic EL element is not deteriorated. Specifically, methods such as sputtering, counter target sputtering, vapor deposition or CVD are preferred.

These transparent inorganic materials are preferably amorphous since the amorphous films have a high effect of shielding moisture, oxygen, low molecular monomers and so on and suppress the deterioration of the organic EL element.

Examples of a sealing liquid constituting the passivation layer include fluorinated hydrocarbons and fluorinated olefin oligomers.

An aromatic ring containing compound, a fluorine skeleton containing compound, a bromine containing compound, or a sulfur containing compound, and compounds having a high refractive index, for example, metalic compounds such as alkoxytitanium (dimethoxytitanium, diethoxytitanium) and alkoxytitaniums may be added to adjust a refractive index.

The thickness of a passivation layer is not limited but the following relation is preferably satisfied.

$$0.001\mu m < T1+T2 < 200\mu m$$

wherein T1 is the thickness of a first passivation layer and T2 is the thickness of a second passivation layer. If (T1+T2) is 0.001μm or less, a passivation layer may almost be mono-atomic layer and have an island-like structure without densification. As a result, the passivation layer may lose a passivating effect, i.e., blocking volatile components from organic luminescent mediums and color conversion layers. If (T1+T2) is 200μm or more, there is the following disadvantageous possibility. When various color conversion layers are arranged corresponding to organic EL pixels respectively for multi-color or full-color display, the distance between corresponding an organic EL pixel and a color conversion layer becomes larger and light emitted from the organic EL pixel is liable to enter into color conversion layers other than the corresponding color conversion layer. Such color mixture reduces the color reproducibility of an organic EL display and increases its viewing angle dependency. That is, the display properties of an organic EL display are remarkably degraded.

The following relation is more preferred.

$$0.01\mu m < T1+T2 < 10\mu m$$

Preferably, a first passivation layer closely contacts organic EL elements and a second passivation layer closely contacts color conversion layers.

5. Flattening layer

A flattening layer, which flattens color conversion layers formed on a transparent substrate, may be made of transparent materials. For example, the same materials as those used in a passivation layer may be preferably used as a material of a flattening layer.
The thickness of a flattening layer is not limited but preferably thinner to make an organic EL display thin. For example, the thickness of both a flattening layer and color conversion layers is preferably 1μm to 10μm.

6. Color conversion layer

The color conversion layer adjusting and/or converting a luminescent color of organic EL element contains the following three cases: (i) color filter, (ii) fluorescent medium and (iii) combination of a color filter and a fluorescent medium.
The color conversion layer preferably contains a fluorescent medium. The fluorescent medium enables the emission of color light other than inherent organic EL light and the strengthening of weak color light. Thus power consumption of an organic EL display can be reduced.
Among above (i) to (iii), the combination of a color filter and a fluorescent medium (iii) is very preferably because of improving the brightness despite low-power, the color purity of display, and the balance of display colors at the time of emitting each of three primary colors.
For example, when the organic EL element emits blue light, a blue pixel has only a blue color filter, a green pixel has a fluorescent medium converting blue light to green light and a green color filter, and a red pixel has a fluorescent medium converting blue light to red light and a red color filter.
The follow will describe the constitution of a color filter and a fluorescent medium or the like.

(i) Color filter
The color filter is to decompose or cut light to adjust color or improve contrast.
Examples of materials for the color filter include the following dyes or solid objects in which the same dye is dissolved or dispersed in a binder resin.
Red (R) dye:

It is possible to use only one or a mixture of at least two and more selected from Perylene pigments, lake pigments, azoic pigments, quinacridone pigments, anthraquinone pigments, anthracene pigments, isoindorine pigments, isoindorinone pigments, diketopyrrolopyrrole pigments and so on.

Green (G) dye:

It is possible to use only one or a mixture of at least two and more selected from halogen-multisubstituted phthalocyanine pigments, halogen-multisubstituted copper phthalocyanine dyes, triphenylmethane basic dyes, azo dyes, isoindorine pigments, isoindorinone pigments and so on.

Blue (B) dye:

It is possible to use only one or a mixture of at least two and more selected from copper phthalocyanine dyes, indanthrone pigments, indophenol pigments, cyanine pigments and dioxazin pigments and so on.

The binder resin for color filters is preferably a material having transparency (transmittance in the visible light region: 50% or more). Examples thereof are transparent resins (polymers) such as polymethyl methacrylate, polyacrylate, polycarbonate, polyvinyl alcohol, polyvinyl pyrrolidone, hydroxyethylcellulose, and carboxymethylcellulose. It can be used as one or a mixture of two or more thereof.
In the case that the color filter is formed by a printing method such an ink-jet method, a printing ink (medium) using a transparent resin can be used. For example, one or two or more can be selected from transparent resins such as polyvinyl chloride resins, polyvinylidene chloride resins, melamine resins, phenol resins, alkyd resins,

EP 1 553 807 A1

epoxy resins, polyurethane resins, polyester resins, maleic acid resins, compositions of monomers, oligomers and polymers of polyamide resins, polymethyl methacrylate, polymethacrylate, polycarbonate, polyvinyl alcohol, polyvinyl pyrrolidone, hydroxyethylcellulose or carboxymethylsellulose.

When photolithography is used for the formation of the color filter, a photosensitive resin can be preferably applied. Examples thereof are photo-setting resist materials having reactive vinyl groups such as acrylic acid type, methacrylic acid type, polyvinyl cinnamate type and cyclic rubber type. One or a mixture of two and more thereof can be used.

In the case that the fluorescent medium is made of a fluorescent dye and such a resin, the fluorescent medium is preferably formed by mixing, dispersing or dissolving the fluorescent dye and the resin with an appropriate solvent to prepare a liquid material; making the liquid material into a film by spin coating, roll coating, casting or the like; and subsequently patterning the film into a desired pattern by photolithography, ink-jet, screen printing or the like.

The thickness of the color filter is not particularly limited. For example, the thickness is preferably 10nm to 1,000μm, more preferably 0.5μm to 500μm, and still more preferably 1μm to 100μm.

(ii) Fluorescent medium

The fluorescent medium has a function of absorbing luminescence of the organic EL element to give fluorescence having a longer wavelength.

Each of the fluorescent mediums is preferably arranged correspondingly to the emitting area of the organic EL element, for example, the position where the upper electrode and the under electrode cross each other. If the organic emitting layer at the intersections of the upper electrode and the under electrode emits light, the respective fluorescent medium layer receives the light to emit light having a different color (wavelength), which can be taken out.

The constituent material of the fluorescent medium is not particularly limited and is made of, for example, a fluorescent dye and a resin, or only a fluorescent dye. The fluorescent dye and the resin may be solid where a fluorescent dye is dissolved or dispersed in a pigment resin and/or a binder resin.

Specific examples of the fluorescent dye will be described. Examples of a fluorescent dye for changing near-ultraviolet to violet light emitted from the organic EL element to blue light include stylbene dyes such as 1,4-bis(2-methylstyryl)benzene (Bis-MBS) and trans-4,4'-diphenylstylbene (DPS); and coumarin dyes such as 7-hydroxy-4-methylcoumarin (coumarin 4).

Examples of a fluorescent dye for changing blue, bluish green or white light emitted from the organic EL element to green light include coumarin dyes such as 2,3,5,6-1H,4H-tetrahydro-8-trifluoromethylquinolidino(9,9a,1-gh)coumarin (coumarin 153), 3-(2'-benzothiazolyl)-7-diethylaminocoumarin (coumarin 6) and 3-(2'-benzimidazolyl)-7-N,N-diethylaminocoumarin (coumarin 7); Basic Yellow 51, which is a coumarin type dye; and naphthalimide dyes such as Solvent Yellow 11 and Solvent Yellow 116.

Examples of a fluorescent dye for changing blue to green light or white light emitted from the organic EL element to orange to red light include cyanine dyes such as 4-dicyanomethylene-2-methyl-6-(p-dimethylaminostyryl)-4H-pyran (DCM); pyridine dyes such as 1-ethyl-2-(4-(p-dimethylaminophenyl)-1,3-butadienyl)-pyridinium-perchlorate (pyridine 1); rhodamine dyes such as Rhodamine B and Rhodamine 6G; oxadine dyes; basicviolet 11; and coumarin 6.

Various dyes (direct dyes, acidic dyes, basic dyes, disperse dyes and so on) can be selected as fluorescent dyes if they have fluorescent properties.

The fluorescent dye that has been beforehand kneaded into a pigment resin may be used. Such pigment resins include polymethacrylic acid esters, polyvinyl chlorides, vinyl chloride vinyl acetate copolymers, alkyd resins, aromatic sulfonamide resins, urea resins, melamine resins and benzoguanamine resins.

Further inorganic fluorescent materials can also be used as a fluorescent dye, which materials are made of inorganic materials such as metallic compounds and absorb visible light to emit fluorescence longer than the visible light. The surface of the inorganic fluorescent materials may be decorated with organic materials such as long-chain alkyl groups and phosphoric acid to improve their dispersibility into a binder resin.

Specifically the following inorganic fluorescent materials can be used.

(a) Metal oxides doped with transition metal ions

There are exemplified metal oxides such as $Y_2O_3$, $Gd_2O_3$, $ZnO$, $Y_3Al_5O_{12}$ and $Zn_2SiO_4$ doped with transition metal ions that absorb visible light such as $Eu^{2+}$, $Eu^{3+}$, $Ce^{3+}$ and $Tb^{3+}$.

(b) Metal chalcogenides doped with transition metal ions

There are exemplified metal chalcogenides such as $ZnS$, $CdS$ and $CdSe$ doped with transition metal ions that absorb visible light such as $Eu^{2+}$, $Eu^{3+}$, $Ce^{3+}$ and $Tb^{3+}$.

(c) Materials that absorb visible light to emit light by using the band gap of semiconductors

There are exemplified semiconductor fine particles such as $CdS$, $CdSe$, $CdTe$, $ZnS$, $ZnSe$ and $InP$. As described in JP-A-2002-510866 and the like, semiconductors are shrinked down to nanosize to control their band gap, thereby changing the wavelength of absorption-fluorescent light.

In inorganic fluorescent materials, the surface may be decorated with, for example, organic materials and metal oxides such as silica to prevent the removal of S, Se and the like by a reactive component of a binder resin. For example, the surface of CdSe fine particles may be coated with a shell of a semiconductive material with a higher band gap energy such as ZnS. This facilitates the entrapment of electrons generated in central fine particles.

The above fluorescent dyes may be used alone or in combination of two or more.

The same binder resins for the color filter can be used here.

The same forming methods for the color filter can be used for the fluorescent medium.

The thickness of the fluorescent medium is not particularly limited. For example, the thickness is preferably 10nm to 1,000μm, more preferably 0.1μm to 500μm, and still more preferably 5μm to 100μm.

7. Transparent substrate

In order to prevent moisture from invading the inside of the organic luminescent medium, it is preferred that the transparent substrate covers at least the emitting area of the organic EL display.

As such a transparent substrate, the same materials for the supporting substrate can be used. In particular, a glass plate or a ceramic substrate having a high effect of shielding moisture or oxygen can be used. The form of the transparent substrate is not particularly limited, but preferably, for example, a plate or a cap. For example, in the case of a plate form, the thickness thereof is preferably in the range of 0.01 to 5mm.

It is also preferred that the transparent substrate is fitted into a groove or the like made in a part of the supporting substrate under pressure and then fixed thereto, or that it is fixed to a part of the supporting substrate with a photo-curing adhesive agent or the like.

[Examples]

Example 1

(1) Formation of TFT substrate

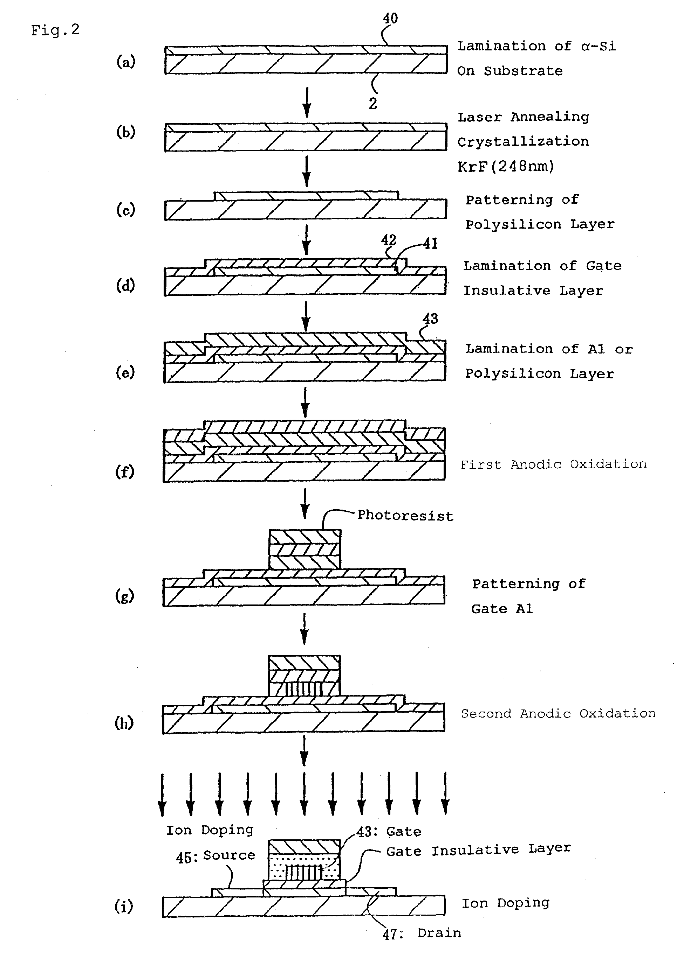

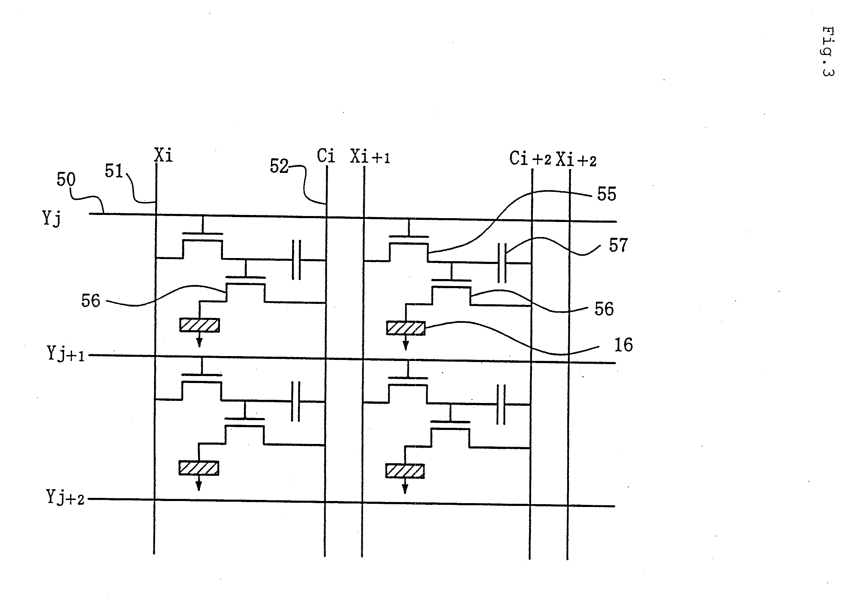

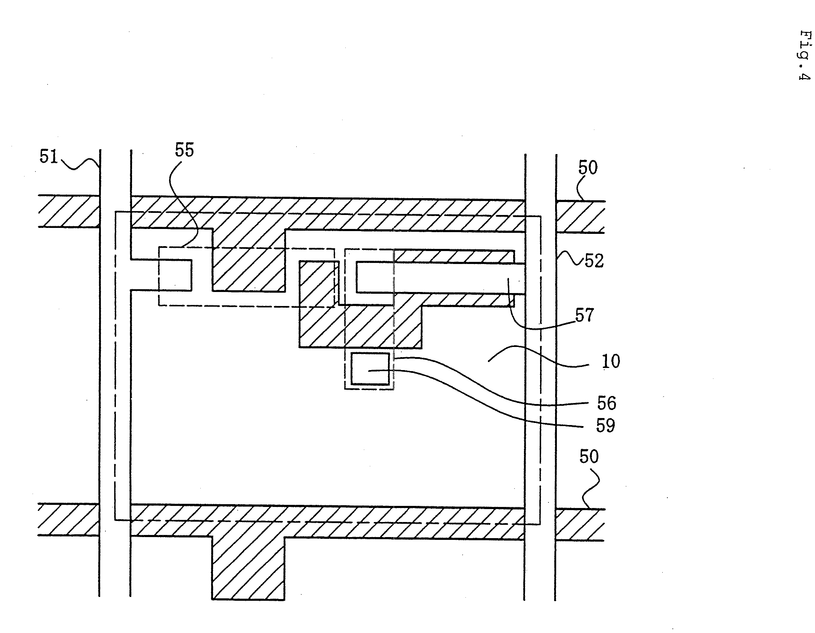

Figs. 2 (a) to (i) are views showing the steps of forming a polysilicon TFT. Fig. 3 is a circuit diagram showing the connection structure of electric switch with the polysilicon TFT. Fig. 4 is a plane view showing the connection structure of electric switch with the polysilicon TFT.

Firstly an α-Si layer 40 was laminated on a glass substrate 2 of 112mm x 143mm x 1.1mm (OA2 glass, Nippon Electric Glass Co., Ltd.) by low pressure chemical vapor deposition (LPCVD) and the like (Fig. 2 (a)). Next the α-Si layer 40 was irradiated with an excimer laser such as a KrF (248nm) laser to be subjected to annealing crystallization, thereby converting α-Si to polysilicon (Fig. 2 (b)). This polysilicon was patterned into an island form by photolithography (Fig. 2 (c)). An insulative gate material 42 was laminated on the island-like polysilicon 41 and the surface of the substrate 2 by chemical vapor deposition (CVD) and the like to form a gate oxide insulative layer 42 (Fig. 2 (d)). A gate electrode 43 was then formed as a film by depositing or sputtering (Fig. 2 (e)), and patterned with anodization (Figs. 2 (f) to (h)). Further doping regions were formed by ion doping (ion implantation), thereby forming active layers as a source 45 and a drain 47 to obtain a polysilicon TFT (Fig. 2 (i)). At this time, the gate electrode 43 (and a scanning electrode 50 and a bottom electrode of a capacitor 57 shown in Fig. 4) was Al, while the source 45 and drain 47 of TFT were of n+ type.

Next a 500nm-thick inter-insulator ($SiO_2$) was formed on the active layers by CRCVD. Thereafter signal electrode lines 51, common electrode lines 52 and top electrodes 57 (Al) of capacitors were formed. The source electrodes of second transistors (Tr2) 56 were connected to the common electrodes. The drains of first transistors (Tr1) 55 were connected to the signal electrodes. Refer to Figs. 3 and 4. Each TFT was connected to each electrode by properly opening the inter-insulator $SiO_2$ by wet etching with hydrofluoric acid.

Then Cr and ITO films were sequentially deposited by sputtering in thicknesses of 2000Å and 1300Å, respectively. A positive resist (HPR204, FUJIFILM Arch Co., Ltd.) was applied on the substrate by spin coating. The resultant substrate was exposed to ultraviolet rays with a photo mask of 90μm x 320μm for a dot pattern, subjected to development with a developing solution of TMAH (tetramethy ammonium hydroxide) and baked at 130°C to obtain a resist pattern.

Next ITO in the exposed parts was etched by an ITO etchant of 47% hydrobromic acid and then Cr was etched by cerium nitrate ammonium/perchloric acid aqueous solution (HCE: NAGASE & Co., Ltd.). The resist was processed by a stripping solution mainly containing ethanolamine (N303: NAGASE & Co., Ltd.) to produce a Cr/ITO pattern (under electrode: anode).

At this time, Tr2 56 was connected to the under electrode 10 via an opening 59 (Fig. 4).

As a second inter-insulative film, a negative resist (V259BK: Nippon Steel Chemical Co., Ltd.) was applied by spin coating, exposed to ultraviolet rays and developed with a TMAH (tetramethyl ammonium hydroxide) developer. The obtained film was baked at 180°C to produce an organic inter-insulative film coating Cr/ITO edges (the opened part of ITO was 70μm x 200μm) (not shown).

(2) Formation of organic EL element

The substrate with the inter-insulative film thus obtained was subjected to ultrasonic cleaning with purified water and isopropyl alcohol, dried with air blow and thereafter cleaned with ultraviolet rays.

The TFT substrate was moved into an organic deposition device (ULVAC Co., Ltd.) and fixed in a substrate holder. Heating boards made of molybdenum were filled in advance 4,4',4"-tris[N-(3-methylphenyl)-[N-phenylamino] triphenylamine(MTDATA) and 4,4'-bis[N-(1-naphtyl)-N-phenylamino]biphenyl(NPD) as a hole injecting material, 4,4'-bis(2,2'-diphenylvinyl)biphenyl(DPVBi) as a host of luminescent material, 1,4-bis[4-(N,N'-diphenylaminostyrylbenzene)](DPAVB) as a dopant, tris(8-quinolinol)aluminum (Alq) and lithium as electron injecting material and cathode, respectively. In addition, an IZO (descrived before) target was attached in another sputtering vessel as a taking out electrode of cathode.

After the pressure in a vacuum vessel was reduced to 6.65 x $10^{-5}$ Pa, from a hole-injecting layer to a cathode were laminated in the following order by vacuuming one time, while maintaining vacuum.

Firstly MTDATA was deposited in a thickness of 60nm at a deposition speed of 0.1 to 0.3 nm/second, and NPD was deposited in a thickness of 20nm at a deposition speed of 0.1 to 0.3 nm/second, as a hole injecting layer; DPVBi and DPAVB were co-deposited in a thickness of 50nm at a deposition speed of 0.1 to 0.3 nm/second and 0.03 to 0.05 nm/second, respectively as an emitting layer; Alq was deposited in a thickness of 20nm at 0.1 to 0.3 nm/second as an electron injecting layer; and Alq and Li were co-deposited in a thickness of 20nm at 0.1 to 0.3 nm/second and 0.005 nm/second, respectively as a cathode.

Next the substrate was moved in a sputtering vessel. An IZO film was formed at a depositing rate of 0.1 to 0.3 nm/second in a thickness of 200nm as a taking out electrode of under electrode to obtain an organic EL element.

(3) Formation of passivation layer and organic EL element substrate

Next as a passivation layer, $SiO_xN_y$ (O/O+N=50%: atomic ratio) was deposited by low temperature CVD to form a 200nm-thick transparent inorganic film on the upper electrode of the organic EL element. An organic EL element substrate was thus obtained.

(4) Formation of color conversion substrate

A black matrix (BM) material, V259BK (Nippon Steal Chemical Co., Ltd.) was spin-coated on a supporting substrate (a transparent substrate) of 102mm by 133mm by 1.1mm (OA2 glass, Nippon Electric glass Co., Ltd.). Thereafter, it was exposed to ultraviolet rays with a photo mask for making a lattice pattern, developed with a developing solution of 2% aqueous solution of sodium carbonate and baked at 200°C to obtain a black matrix pattern (film thickness of 1.5 μm).

Next, a blue filter material containing a pigment of copper phthalocyanine type, V259B (Nippon Steal Chemical Co., Ltd.), was spin-coated. The resultant substrate was exposed to ultraviolet rays with a photo mask for forming the pattern of 320 rectangle stripes (90μm line, 240μm gap) in alignment with the position of the black matrix, developed with a 2% aqueous solution of sodium carbonate and baked at 200°C to form the pattern of a blue filter (film thickness of 1.5μm).

Next, a green filter material containing azo based pigment and phthalocyanine bromide type one V259G (Nippon Steal Chemical Co., Ltd.), was spin-coated. The resultant substrate was exposed to ultraviolet rays with a photo mask for forming the pattern of 320 rectangle stripes (90μm line 240μm gap) in alignment with the position of the black matrix, developed with a 2% aqueous solution of sodium carbonate and baked at 200°C to form the pattern of a green filter (film thickness of 1.5μm) adjacent the blue filter.

Next, a red filter material containing an azo based pigment and diketopyrrolopyarte type one V259R (manufactured by Nippon Steal Chemical Co., Ltd.) was spin-coated. The resultant substrate was exposed to ultraviolet rays with a photo mask for forming the pattern of 320 rectangle stripes (90μm line, 240μm gap) in alignment with the position of the black matrix, developed with a 2% aqueous solution of sodium carbonate and baked at 200°C to form the pattern of a red filter (film thickness of 1.5μm) between the blue filter and green filter.

Coumarin 6 was dissolved in an acrylic negative photoresist (V259PA, solids content 50%, Nippon Steel Chemical Co., Ltd.) at a coumarin concentration of 0.04 mol/kg (solids) to prepare ink as a material for green fluorescent medium.

This ink was spin-coated on the above substrate. The resultant substrate was exposed to ultraviolet rays above the green filter, developed with a 2% aqueous solution of sodium carbonate and baked at 200°C to form the pattern of a green converting film (film thickness 10µm) above the green filter.

Next 0.53g of Coumarin 6, 1.5g of basic violet 11 and 1.5g of Rhodamine 6G were dissolved in 100g of an acrylic negative photoresist (V259PA, solids content 50%, Nippon Steel Chemical Co., Ltd.) to prepare ink as a material for red fluorescent medium.

This ink was spin-coated on the above substrate. The resultant substrate was exposed to ultraviolet rays above the red filter, developed with a 2% aqueous solution of sodium carbonate and baked at 180°C to form the pattern of a red converting film (film thickness 10µm) above the red filter.

Next, an acrylic acid based thermosetting resin (V259PH, Nippon Steel Chemical Co., Ltd.) was spin-coated on the above substrate as a flattening film and baked at 180°C to form a 12 µm-thick flattening film.

Next, as a passivation layer, $SiO_xN_y$ (O/O+N=50%: atomic ratio) was deposited by low temperature CVD in a thickness of a 200nm on the flattening film. A color conversion substrate was thus obtained.

(5) Attachment of upper and lower substrates

The organic EL element substrate and the color conversion substrate produced above were placed in a dry box through which dried nitrogen flowed. A cationic photosetting type adhesive (3102: Three Bond Co., Ltd.) was applied around the display part (emission part) of the organic EL element substrate by using a dispenser.

Next, these substrates were attached to each other by photoirradiation positioning an alignment mark. Thereafter, a space corresponding to the display part was filled with an inert liquid (fluorohydrocarbon: manufactured by Three M Co., Ltd., FC70) that have been degassed in advance.

(6) Evaluation of reliability of organic EL display

An active organic EL display (Figure 1) was produced as described above. Upon applying a voltage of DC 7 V between the under electrode (ITO/Cr) and upper electrode (IZO) of the display (under electrode: (+), upper electrode: (-)), light was emitted the intersections of electrodes, pixels.

Next, a storage test was carried out at 85 °C for 500 hours. The reduction ratio of light emission pixel area (%) was measured under a microscopy. The display had a reduction ratio of 3%, that is, it was excellent in durability. The reduction ratio was obtained using the following equation.

"Reduction ratio (%)" = ["Light emission pixel area

before storage test" - "Light emission pixel area after

storage test"] x 100 / "Light emission pixel area before

storage test"

Comparative Example 1

An organic EL display (Figure 5) was produced under the same conditions as those of Example 1 except that a passivation layer was not formed on the color conversion substrate. The reliability of organic EL display was evaluated in the same way as in Example 1.

As a result, the reduction ratio was 12%. This organic EL display was inferior to the display of Examples in durability.

Comparative Example 2

An organic EL display (Figure 6) was produced under the same conditions as those of Example 1 except that a passivation layer was not formed on the organic EL element substrate. The reliability of organic EL display was evaluated in the same way as in Example 1.

As a result, the reduction ratio was 10%. This organic EL display was inferior to that of Examples in durability.

As stated above, the durability of organic EL display was improved by forming a passivation layer on an organic EL element substrate and a color conversion substrate. The evaluation results are shown in Table 1.

Table 1

| Durability comparison of organic EL displays | | |
|---|---|---|
| | Organic EL display | Reduction ratio of light emission pixel area (%) |
| Example 1 | Figure 1 | 3 |
| Comparative Example 1 | Figure 5 | 12 |
| Comparative Example 2 | Figure 6 | 10 |

Industrial Utility

The present invention can provide an organic EL display excellent in duability with less occurrence of non-emitted parts such as dark spots and a production method thereof.

**Claims**

1.   An organic electroluminescent display comprising:

a supporting substrate;
an organic electroluminescent element;
a first passivation layer;
a second passivation layer;
a color conversion layer for adjusting and/or converting the color of a light emitted from the organic electroluminescent element; and
a transparent substrate formed in sequence.

2.   An organic electroluminescent display according to claim 1, wherein the following formula is satisfied,

$$0.001 \, \mu m < T1+T2 < 200 \, \mu m$$

wherein T1 is the film thickness of the first passivation layer, and T2 is the film thickness of the second passivation layer.

3.   An organic electroluminescent display according to claim 1, further comprising an intermediate layer between the first passivation layer and the second passivation layer.

4.   An organic electroluminescent display according to claim 3, wherein the intermediate layer comprises an inert fluid.

5.   An organic electroluminescent display according to claim 1, wherein the color conversion layer comprises a fluorescent medium.

6.   A process for producing an organic electroluminescent display, comprising:

arranging an organic electroluminescent element and a first passivation layer on a supporting substrate to form a first substrate;
arranging a color conversion layer for adjusting and/or converting the color of a light emitted from the organic electroluminescent element, and a second passivation layer on a transparent substrate to form a second substrate; and
attaching the first substrate to the second substrate such that the first passivation layer faces the second passivation layer.

Fig. 1

EP 1 553 807 A1

5...Color Conversion Layer

6...Transparent Substrate

9...Flattening Layer

4...Second Passivation Layer

3...First Passivation Layer

2...Organic EL Element

1...Supporting Substrate

8...Insulative Member

7...TFT

Fig.2

(a)     Lamination of α-Si On Substrate

(b)     Laser Annealing Crystallization KrF(248nm)

(c)     Patterning of Polysilicon Layer

(d)     Lamination of Gate Insulative Layer

(e)     Lamination of Al or Polysilicon Layer

(f)     First Anodic Oxidation

Photoresist

(g)     Patterning of Gate Al

(h)     Second Anodic Oxidation

Ion Doping

45: Source     43: Gate     Gate Insulative Layer

(i)     Ion Doping

47: Drain

Fig. 3

EP 1 553 807 A1

Fig.4

Fig.5

Fig.6

## INTERNATIONAL SEARCH REPORT

| | International application No. |
|---|---|
| | PCT/JP03/13234 |

**A. CLASSIFICATION OF SUBJECT MATTER**
Int.Cl⁷ H05B33/04, H05B33/14, H05B33/10, H05B33/12

According to International Patent Classification (IPC) or to both national classification and IPC

**B. FIELDS SEARCHED**

Minimum documentation searched (classification system followed by classification symbols)
Int.Cl⁷ H05B33/00-33/28

Documentation searched other than minimum documentation to the extent that such documents are included in the fields searched
| Jitsuyo Shinan Koho | 1922-1996 | Toroku Jitsuyo Shinan Koho | 1994-2004 |
| Kokai Jitsuyo Shinan Koho | 1971-2004 | Jitsuyo Shinan Toroku Koho | 1994-2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 8-222369 A (Idemitsu Kosan Co., Ltd.),<br>30 August, 1996 (30.08.96),<br>Par. Nos. [0010] to [0014], [0047], [0050],<br>[0056], [0058]; Fig. 6<br>& WO 96/25020 A1 & JP 8-279394 A<br>& EP 809420 A1, B1 & US 5909081 A<br>& JP 3187695 B2 & DE 69623443 E | 1-3,5,6<br>4 |
| Y | JP 2001-217072 A (Semiconductor Energy Laboratory<br>Co., Ltd.),<br>10 August, 2001 (10.08.01),<br>Par. Nos. [0006] to [0034], [0081] to [0131];<br>Figs. 1, 6<br>& EP 1085576 A2 & CN 1289151 A<br>& KR 2001067183 A & US 6445005 B1<br>& US 2002/0190257 A1 & TW 516244 A<br>& TW 522453 A | 1-3,5 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>19 January, 2004 (19.01.04) | Date of mailing of the international search report<br>03 February, 2004 (03.02.04) |
|---|---|
| Name and mailing address of the ISA/<br>Japanese Patent Office | Authorized officer |
| Facsimile No. | Telephone No. |

Form PCT/ISA/210 (second sheet) (July 1998)

**INTERNATIONAL SEARCH REPORT**

| International application No. |
| --- |
| PCT/JP03/13234 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | JP 2002-134288 A (TDK Corp.),<br>10 May, 2002 (10.05.02),<br>Par. Nos. [0036] to [0037], [0231] to [0247],<br>[0254]; Fig. 5<br>(Family: none) | 1-3,5 |
| Y | JP 8-279394 A (Idemitsu Kosan Co., Ltd.),<br>22 October, 1996 (22.10.96),<br>Par. Nos. [0045] to [0048], [0058]; Fig. 6<br>& WO 96/25020 A1 & JP 8-222369 A<br>& EP 809420 A1 & US 5909081 A<br>& DE 69623443 E | 1-2,5 |
| X<br>A | JP 2001-93661 A (Semiconductor Energy Laboratory<br>Co., Ltd.),<br>06 April, 2001 (06.04.01),<br>Par. Nos. [0040] to [0047]; Fig. 6<br>& US 2002/0125817 A | 1<br>2-6 |
| A | JP 8-124677 A (Idemitsu Kosan Co., Ltd.),<br>17 May, 1996 (17.05.96),<br>Par. Nos. [0012] to [0035]; Fig. 1<br>(Family: none) | 4 |
| P,X | JP 2003-282261 A (Fuji Electric Co., Ltd.),<br>03 October, 2003 (03.10.03),<br>Full text; all drawings<br>(Family: none) | 1-3,5-6 |
| A | JP 2001-338754 A (Casio Computer Co., Ltd.),<br>07 December, 2001 (07.12.01),<br>Par. Nos. [0005] to [0022]; Fig. 1<br>(Family: none) | 3-4 |

Form PCT/ISA/210 (continuation of second sheet) (July 1998)